# EUROPÄISCHE PATENTSCHRIFT

(11) **EP 3 390 683 B1**
(45) Veröffentlichungstag und Bekanntmachung des Hinweises auf die Patenterteilung: **26.01.2022**
(21) Anmeldenummer: 17708225.2
(22) Anmeldetag: 01.03.2017
(51) Int. Cl.: C23C 14/06, C23C 14/18, F16J 9/26, C23C 14/04, C23C 28/04, C23C 28/00, C23C 14/58

(54) **BESCHICHTETER KOLBENRING MIT SCHUTZSCHICHT**
COATED PISTON RING HAVING A PROTECTIVE LAYER
SEGMENT DE PISTON REVÊTU D'UNE COUCHE DE PROTECTION

(30) Priorität: 20.04.2016 DE 102016107296; 02.05.2016 DE 102016108088
(43) Veröffentlichungstag der Anmeldung: 24.10.2018
(73) Patentinhaber: Federal-Mogul Burscheid GmbH, 51399 Burscheid (DE)
(72) Erfinder: ESSER, Peter-Klaus, 51515 Kürten (DE)
(74) Vertreter: Becker & Kurig Partnerschaft Patentanwälte PartmbB
(86) Internationale Anmeldenummer: PCT/EP2017/054747
(87) Internationale Veröffentlichungsnummer: WO 2017/182185

(56) Entgegenhaltungen:
- WO-A1-2012/083930
- DE-A1-102008 037 871
- DE-A1-102011 003 254
- DE-A1-102015 104 103
- US-A1- 2013 209 767

## Beschreibung

Die vorliegende Erfindung betrifft eine Beschichtung eines Kolbenrings, insbesondere eines Verdichtungsrings, für die Verwendung an einem Kolben eines Verbrennungsmotors.

### Stand der Technik

Gleitelemente wie Kolbenringe in Verbrennungsmotoren müssen über eine möglichst lange Lebensdauer sowohl bei möglichst geringer Reibung als auch mit geringem Verschleiß arbeiten. Um die unmittelbar mit dem Kraftstoffverbrauch des Verbrennungsmotors gekoppelte Reibung zu reduzieren und die Lebensdauer zu erhöhen, ist grundsätzlich bekannt, derartige Gleitelemente mit einer reibungsreduzierenden Verschleißschutz-Beschichtung zu versehen. Hierfür wird beispielsweise eine DLC-Schicht (Diamond-Like-Carbon) oder eine Nitrierschicht verwendet, was dem Fachmann grundsätzlich bekannt ist. Für die Auftragung einer DLC-Schicht werden verschiedene Verfahren verwendet. Aufgrund hoher Beschichtungsraten und verhältnismäßig geringer Kosten wird oft ein PA-CVD-Verfahren (Plasma-Assisted-Chemical-Vapor-Deposition ) verwendet. Auch bekannt ist die Verwendung von PVD-Verfahren (Physical-Vapor-Deposition).

Aus der deutschen Patentanmeldung DE 102008037871 A1 ist ein Gleitelement bekannt, bei dem auf der Lauffläche eine Schichtanordnung aufgebracht wird, wobei insbesondere auf eine Oberfläche zuerst eine Schutzschicht mit einer Härte von über 5GPa aufgebracht wird, auf die eine Laufschicht aufgetragen wird, die eine geringere Festigkeit als die Schutzschicht aufweist. Die Schutzschicht weist dabei eine geringere Gleitfähigkeit als die Laufschicht auf, soll aber einer Zerstörung der Oberfläche bei einem Versagen der Laufschicht entgegenwirken und stellt somit eine verbesserte Notlaufeigenschaft bereit.

In der deutschen Patentanmeldung DE 102015104103 A1 ist ein weiteres Gleitelement bekannt, bei dem ein Gleitfilm auf einem Basismaterial angeordnet ist, wobei der Gleitfilm mehrere Schichten umfasst, wobei eine äußere Schicht einen speziellen, Bor enthaltenden amorphen Kohlenstoff aufweist, der bis 50% Bor (B) und 5 bis 50% Wasserstoff (H) enthält.

Bei Verbrennungsmotoren sind dabei insbesondere die Ansprüche an den dem Brennraum nächstgelegenen Kolbenring, dem Verdichtungsring, im Hinblick auf Verschleiß und Passgenauigkeit besonders hoch, um die Anforderungen an wenig Blowby und geringen Ölverbrauch zu erfüllen, da der Verdichtungsring dem höchsten Gasdruck und der höchsten Temperaturbelastung ausgesetzt ist. Es besteht also Bedarf daran, die Eigenschaften von mit Funktions-/Verschleißschutz-Beschichtungen versehenen Kolbenringen weiter zu verbessern.

Für eine erhöhte Lebensdauer des Ringes ist weiterhin ein optimales Einlaufverhalten notwendig. Durch das zusätzliche Zusammenspiel der Eigenspannungen von Grundwerkstoff und von Beschichtung, die unterschiedliche Festigkeiten aufweisen, muss der Kolbenring in seiner Ringkontur optimiert und beurteilbar sein, um zu vermeiden, dass die Beschichtung frühzeitig beschädigt wird.

### Zusammenfassung der Erfindung

Erfindungsgemäß wird die Aufgabe gelöst durch einen Kolbenring mit den Merkmalen des Anspruchs 1, sowie durch das Verfahren zur Herstellung eines Kolbenrings mit den Merkmalen des Anspruchs 10, wobei vorteilhafte Ausführungen in den abhängigen Ansprüchen beschrieben sind. Der Kolbenring umfasst einen Kolbenringkörper auf dessen Außenfläche zumindest auf der Lauffläche eine DLC-Schicht als Funktionsschicht aufgebracht ist, wobei auf der Funktionsschicht zumindest auf Teilflächen der Kolbenringlauffläche eine Schutzschicht aufgebracht ist, und wobei die Schutzschicht aus einem Material besteht, das von dem Material der Funktionsschicht unterschiedlich ist und eine höhere Temperaturbeständigkeit als dieses aufweist und wobei die Schutzschicht in Form oberflächlicher Einlagerungen in Vertiefungen der Funktionsschicht vorliegt.

Gemäß einem Aspekt kann die Schutzschicht durch ein PVD-Verfahren aufgebracht sein.

Gemäß einem weiteren Aspekt der vorliegenden Erfindung beträgt die Dicke der Schutzschicht weniger als 5 µm, bevorzugt weniger als 2 µm, am meisten bevorzugt weniger als 1 µm.

Gemäß einem anderen Aspekt kann die Schutzschicht aus einem Metall oder einem Metallnitrid bestehen.

Gemäß einem Aspekt ist auf der gesamten Kolbenringlauffläche eine Schutzschicht aufgebracht.

Gemäß einem weiteren Aspekt der vorliegenden Erfindung kann auf der Kolbenringlauffläche in einem Bereich um den Pivotpunkt keine Schutzschicht aufgebracht sein und auf die restliche Kolbenringlauffläche, einschließlich evtl. der Laufkanten, außerhalb dieses Bereiches eine Schutzschicht aufgebracht sein.

Gemäß einem Aspekt kann die Funktionsschicht/Verschleißschutzschicht als eine wasserstoff- bzw. halogenfreie DLC-Schicht gebildet sein.

Gemäß einem Aspekt liegt die Schutzschicht in Form oberflächlicher Einlagerungen in

Vertiefungen der Funktionsschicht vor.

Gemäß einem Aspekt können die oberflächlichen Einlagerungen der Schutzschicht bei einer Schichtdicke der Funktionsschicht kleiner als 10 µm einen Flächenanteil zwischen 10% und 30% der Gesamtfläche aufweisen, bzw. bei einer Schichtdicke der Funktionsschicht größer als 10 µm einen Flächenanteil zwischen 20% und 40% der Gesamtfläche aufweisen.

Gemäß einem Aspekt kann auf der Kolbenringlauffläche der Rauheitswert Rpk im Bereich von 0,03 µm bis 0,1 µm liegen, und der Rauheitswert Rk im Bereich von 0,15 µm bis 0,3 µm liegen.

Weiter wird die Aufgabe erfindungsgemäß gelöst durch ein Verfahren zur Herstellung eines Kolbenrings, umfassend das Bereitstellen eines Kolbenringkörpers; das Aufbringen einer DLC-Schicht als Funktionsschicht zumindest auf die Lauffläche des Kolbenringkörpers; das Aufbringen einer Schutzschicht auf die Funktionsschicht; und teilweises Abtragen der Schutzschicht, so dass nur noch in Vertiefungen der Oberfläche der Funktionsschicht Einlagerungen vorhanden sind.

Gemäß einem Aspekt des Verfahrens kann der Kolbenringkörper vor Aufbringen der Funktionsschicht aufgeraut werden, insbesondere diejenigen Außenflächen, die mit einer Funktionsschicht versehen werden.

Gemäß einem Aspekt des Verfahrens kann die Funktionsschicht durch ein Lichtbogenverfahren oder ein Sputterverfahren aufgebracht werden.

Gemäß einem Aspekt des Verfahrens kann die Funktionsschicht nach ihrem Aufbringen einen Rauheitswert Rpk im Bereich von 0,15 µm bis 0,5 µm aufweisen, und einen Rauheitswert Rk im Bereich von 0,3 µm bis 0,7 µm aufweisen.

Gemäß einem Aspekt des Verfahrens kann die Schutzschicht durch ein PVD-Verfahren aufgebracht werden.

Gemäß einem Aspekt des Verfahrens kann das Material der Schutzschicht ein Metall, eine Metalllegierung oder ein Metallnitrid umfassen, vorzugsweise Chrom, Aluminium, Titannitrid oder Vanadiumnitrid.

Gemäß einem Aspekt des Verfahrens kann die Aufbringdicke des Materials der Schutzschicht zwischen 0,05 µm und 1 µm liegen, bei einer Schichtdicke der Funktionsschicht größer als 20 µm bevorzugt zwischen 0,2 µm und 0,4 µm, bzw. bei einer Schichtdicke der Funktionsschicht kleiner als 20 µm bevorzugt zwischen 0,05 µm und 0,4 µm, weiter bevorzugt zwischen 0,1 µm und 0,2 µm.

Gemäß einem Aspekt des Verfahrens kann der Abtrageschritt Läppen, insbesondere Rundläppen, umfassen.

Gemäß einem weiteren Aspekt des Verfahrens kann der Abtrageschritt fortgesetzt werden, bis der Flächenanteil der oberflächlichen Einlagerungen bei einer Schichtdicke der Funktionsschicht kleiner als 10 µm zwischen 10% und 30% der Gesamtfläche liegt, bzw. bei einer Schichtdicke der Funktionsschicht größer als 10 µm zwischen 20% und 40% der Gesamtfläche liegt.

### Ausführliche Beschreibung der Erfindung

Im Folgenden wird die vorliegende Erfindung anhand verschiedener Ausführungsformen und Ausgestaltungsmerkmale beschrieben.

Die Erfindung betrifft eine Schutzschicht für einen mit einer Funktions-/Verschleißschutzschicht versehenen Kolbenring, dabei besteht die Funktionsschicht aus diamantartigen Kohlenstoff (DLC, Diamond-like-Carbon). DLC-Beschichtungen umfassen tetraedrische amorphe Kohlenstoffschichten, auch "ta-C" genannt, die sp³-hybridisierte Bindungen aufweisen, weshalb eine diamantenartige Struktur gebildet wird. Eine derartige harte amorphe Carbon-basierte Schicht kann die Reibung verringern sowie eine Temperaurbeständigkeit im Bereich von etwa 450 bis 550°C und eine Beschichtungsdicke von 2 µm bis zu 40 µm aufweisen. Bevorzugt handelt es sich bei der DLC-Schicht um eine wasserstoff- bzw. halogenfreie DLC-Schicht.

Die DLC-Schicht/Funktionsschicht überdeckt dabei zumindest einen Teilbereich der Kolbenringlauffläche, kann aber gegebenenfalls auch andere Außenflächen-Bereiche des Kolbenrings, z.B. der Kolbenringflanken, überdecken.

Die DLC-Schicht ist weiter mit einer Schutzschicht aus einem Material, das sich vom Material der DLC-Schicht unterscheidet überdeckt und das eine höhere Temperaturbeständigkeit als das Material der DLC-Schicht aufweist, zum Beispiel im Bereich von 550 bis 650°C. Die Überdeckung betrifft dabei zumindest eine Teilfläche der Kolbenringlauffläche, kann sich aber auch über die gesamte Lauffläche erstrecken.

Die Lauffläche des Kolbenrings weist im Allgemeinen ein balliges oder konisches Profil auf, d.h. in einer Schnittdarstellung es Rings verläuft die äußere Linie nicht parallel zur Kolbenachse/Zylinderwand sondern ist nach außen gewölbt bzw. verläuft schräg. Dabei versteht der Fachmann unter dem Begriff "Pivotpunkt" den radial am äußersten gelegenen Punkt der Balligkeit/Konizität (Scheitelpunkt) oder auch den maximalen Punkt des Laufflächenprofils oder auch den Umkehrpunkt des Laufflächenprofils im Einbauzustand des Kolbenrings. In Umlaufrichtung erhält man sozusagen eine "Pivotlinie". Gemäß einer Ausführungsform ist ein Bereich um den Pivotpunkt nicht mit einer Schutzschicht versehen. Es ergibt sich also in Umlaufrichtung eine Art Band auf der Kolbenringlauffläche, auf das keine Schutzschicht aufgebracht ist, dieses Band befindet sich sozusagen in einem Bereich um die "Pivotlinie" herum. Die Bereiche der Lauffläche, einschließlich der Laufkanten, die sich nicht in diesem Bereich um den Pivotpunkt befinden, sind hingegen mit einer Schutzschicht versehen.

Die Dicke der Schutzschicht bewegt sich dabei im Bereich einiger µm, hier sollten 5 µm nicht überschritten werden, vorzugsweise beträgt die Dicke der Schutzschicht weniger als 2 µm, am meisten wird eine Dicke von weniger als 1 µm bevorzugt.

Gemäß einer Ausführungsform findet als Material für die Schutzschicht ein Metall oder ein Metallnitrid Verwendung.

Dem Fachmann sind verschiedene Verfahren bekannt, eine solche Schutzschicht aufzubringen. Einer möglichen Ausführungsform der vorliegenden Erfindung zufolge wird die Schutzschicht auf die DLC-Schicht durch ein PVD-Verfahren (Physical-Vapor-Deposition, physikalische Gasphasenabscheidung) aufgebracht.

Weiter denkbar ist eine zusätzliche Schicht zwischen der DLC-Schicht und der Schutzschicht anzubringen.

Gemäß einer bevorzugten Ausführungsform liegt die Schutzschicht in Form von Einlagerungen in Vertiefungen an der Oberfläche der Funktionsschicht vor. Unter Vertiefungen in der Oberfläche sind hier Vertiefungen zu verstehen, die aufgrund der Rauheit der Oberfläche vorhanden sind. Die Schutzschicht hat dann also nicht die Form einer geschlossenen Fläche, sondern liegt in Form von über die gesamte Fläche verteilten mikroskopisch-kleinen oberflächlichen Einlagerungen vor.

Die Abmessungen der Vertiefungen und der Einlagerungen können durch das Herstellungsverfahren der Funktionsschicht eingestellt werden. Hier hat sich gezeigt, dass für dünnere Funktionsschichten, d.h. hier kleiner 10 µm, ein Flächenanteil der oberflächlichen Einlagerungen an der Gesamtfläche im Bereich von 10% bis 30% zu bevorzugen ist, während bei dickeren Funktionsschichten auch der Flächenanteil größer sein sollte. Genauer wird für Schichtdicken größer 10 µm ein Flächenanteil von 20% bis 40% der Gesamtdicke bevorzugt. Mit zunehmender Dicke der Funktionsschicht sollte also auch der Flächenanteil der oberflächlichen Einlagerungen zunehmen. Der Rauheitswert Rpk auf der Kolbenringlauffläche liegt dabei im Bereich von 0,03 µm bis 0,1 µm; der Rauheitswert Rk auf der Kolbenringlauffläche liegt dabei im Bereich von 0,15 µm bis 0,3 µm.

Erfindungsgemäß wird ein Kolbenring mit einer in Form von oberflächlichen Einlagerungen in der Funktionsschicht vorliegenden Schutzschicht wie im Folgenden beschrieben hergestellt. Auf einen bereitgestellten Kolbenringkörper, zum Beispiel aus Grauguss oder einem Stahl, wird zunächst eine DLC(Diamond-Like-Carbon)-Schicht aufgebracht, die als Funktionsschicht, also als Verschleißschutzschicht, dient. Auf diese DLC-Schicht wird weiter eine Schutzschicht aufgebracht, welche in einem nachfolgenden Abtrageschritt wieder soweit abgetragen wird, dass nur noch in Vertiefungen der DLC-Schicht die zusätzliche Schicht, d.h. die Schutzschicht, vorhanden ist. Es sind also Einlagerungen in, durch die Oberflächenrauheit der DLC-Schicht gegebene, Vertiefungen an der Oberfläche der DLC-Schicht vorhanden.

Durch diese zusätzliche Schicht in Form bevorzugt metallischer Einlagerungen entwickelt sich zwischen Zylinderwand und Kolbenringfläche ein Gemisch aus Öl - Kohlenstoff und zusätzlich metallischer Schutzschicht. Durch den zusätzlichen Abtrag der Schutzschicht wird der Reibwert verringert, so dass das Verschleißverhalten, insbesondere das Einlaufverhalten, verbessert wird. In einem Motorversuch über 100 Stunden konnte festgestellt werden, dass das Einlaufverhalten eines erfindungsgemäß hergestellten Kolbenrings, d.h. mit den zusätzlichen oberflächlichen Einlagerungen in der Verschleißschutzschicht, verbessert wird. Es wurde insbesondere festgestellt, dass der Schichtverschleiß um ca. 15% und der Zwickelverschleiß um ca. 25% verringert werden.

Für solche oberflächlichen Einlagerungen in der DLC-Funktionsschicht muss die DLC-Schicht eine gewisse Rauheit aufweisen. Entsprechend einer Ausführungsform wird diese Rauheit eingestellt durch ein Aufrauen des Kolbenringkörpers vor dem Aufbringen der Funktionsschicht, zumindest an den Stellen, an welchen eine Funktionsschicht aufgebracht werden soll. Diese Rauheit "überträgt" sich dann auf die Oberfläche der Funktionsschicht. Gemäß einer weiteren Ausführungsform wird die DLC-Schicht durch ein Lichtbogenverfahren oder ein Sputterverfahren (beide sind PVD-Verfahren) aufgebracht, um für eine gewisse Grundrauheit zu sorgen. Natürlich ist auch eine Kombination von Aufrauen des Kolbenringkörpers und Aufbringen der DLC-Schicht durch Lichtbogen-/Sputterverfahren denkbar. Bevorzugt weist die Oberfläche der Funktionsschicht (DLC-Schicht), vor dem Aufbringen der Schutzschicht, einen Rauheitswert Rpk im Bereich von 0,15 µm bis 0,5 µm auf, und einen Rauheitswert Rk im Bereich von 0,3 µm bis 0,7 µm auf.

Die Rauheitswerte betreffen im Allgemeinen die gesamte axiale Höhe der Kolbenringlauffläche, bzw bei einer Nacharbeit der Lauffläche kann die (metallische) Schutzschicht auf der Lauffläche verteilt sein, d.h. ober- und unterhalb der Ringanläppung. Diese Bereiche können unterschiedlich breit sein von 0,05 mm bis 4 mm je nach axialer Höhe.

Als Material für die Schutzschicht findet bevorzugt ein Metall, eine Metalllegierung oder eine Metallnitrid Verwendung, vorzugsweise Chrom, Aluminium, Titannitrid oder Vanadiumnitrid. Aufgetragen wird hierbei das Material der Schutzschicht bevorzugt bis zu einer Dicke im Bereich von 0,05 µm bis 1 µm. Weiter bevorzugt wird im Fall einer DLC-Schicht-Dicke größer als 20 µm eine Aufbringdicke des Materials der Schutzschicht zwischen 0,2 µm und 0,4 µm. Im Fall einer DLC-Schicht-Dicke kleiner als 20 µm wird eine Aufbringdicke des Materials der Schutzschicht zwischen 0,05 µm und 0,4 µm bevorzugt, am meisten bevorzugt zwischen 0,1 µm und 0,2 µm. Zum Aufbringen des Materials der Schutzschicht kommt vorzugsweise ein PVD-Verfahren zum Einsatz.

Nach dem Aufbringen einer Schicht des Materials der Schutzschicht wird diese in einem nachfolgenden Abtrageschritt, mittels eines geeigneten Verfahrens, teilweise wieder entfernt. Bevorzugt kommt hier Läppen, insbesondere Rundläppen, zum Einsatz. Das Abtragen wird solange fortgesetzt, bis lediglich in Vertiefungen aufgrund der Rauheit der Oberfläche der DLC-Schicht Einlagerungen des Materials der Schutzschicht vorhanden sind. Auf diese Weise werden oberflächliche Einlagerungen auf der DLC-Schicht gebildet. Bevorzugt wird der Abtrageprozess fortgesetzt, bis der Flächenanteil der oberflächlichen Einlagerungen an der Gesamtfläche bei dünneren DLC-Schichten, d.h. kleiner als 10 µm, im Bereich von 10% bis 30% liegt. Bei dickeren DLC-Schichten, d.h. größer als 10 µm, wird ein Flächenanteil im Bereich von 20% bis 40% bevorzugt. Der Flächenanteil kann hierbei über ein REM(Rasterelektronenmikroskop)-Mappingverfahren bestimmt werden. Mit Gesamtfläche ist hier die gesamte Fläche auf der das erfindungsgemäße Verfahren, einschließend den Abtrageprozess, angewandt wird gemeint, d.h. der Flächenanteil ist der Anteil der oberflächlichen Einlagerungen an der Fläche, auf der das Material der Schutzschicht abgetragen wird. Es ist auch denkbar, nur einen Teil der DLC-Schicht mit einer Schutzschicht zu versehen, und/oder nur auf einer Teilfläche das Material der Schutzschicht abzutragen, während auf anderen Teilflächen die aufgetragene Schutzschicht in ihrer ganzen Dicke bestehen bleibt. Möglich ist weiter das Material der Schutzschicht auf verschiedenen Teilflächen verschieden stark abzutragen, zum Beispiel wäre es denkbar das Material im Stoßbereich des Kolbenrings etwas stärker abzutragen.

Durch das Aufbringen von Material der Schutzschicht auf die Funktionsschicht und den nachfolgenden Abtrageprozess wird der Rauheitswert Rpk um ca. 20% und der Rauheitswert Rk um ca. 30% reduziert. Diese Änderung bezieht sich auf Funktionsschicht mit oberflächlichen Einlagerungen, d.h. nach dem Abtrageschritt, im Vergleich zu Funktionsschicht ohne oberflächliche Einlagerungen, d.h. direkt nach Aufbringen der DLC-Schicht/Funktionsschicht. Die Rauheitswerte werden also deutlich verringert, was zu einer Verbesserung des Verschleißverhaltens führt.

## Patentansprüche

1. Kolbenring, umfassend einen Kolbenringkörper,
wobei auf der Außenfläche des Kolbenringkörpers zumindest auf der Lauffläche eine DLC-Schicht als Funktionsschicht aufgebracht ist,
wobei auf der Funktionsschicht zumindest auf Teilflächen der Kolbenringlauffläche eine Schutzschicht aufgebracht ist,
wobei die Schutzschicht aus einem Material besteht, das von dem Material der Funktionsschicht unterschiedlich ist und eine höhere Temperaturbeständigkeit als dieses aufweist,
wobei die Schutzschicht in Form oberflächlicher Einlagerungen in Vertiefungen der Funktionsschicht vorliegt.

2. Kolbenring gemäß Anspruch 1, wobei die Schutzschicht durch ein PVD-Verfahren aufgebracht wurde.

3. Kolbenring gemäß einem der vorstehenden Ansprüche, wobei die Dicke der Schutzschicht weniger als 5 µm beträgt, bevorzugt weniger als 2 µm, am meisten bevorzugt weniger als 1 µm.

4. Kolbenring gemäß einem der vorstehenden Ansprüche, wobei die Schutzschicht aus einem Metall oder einem Metallnitrid besteht.

5. Kolbenring gemäß einem der vorstehenden Ansprüche, wobei auf die gesamte Kolbenringlauffläche eine Schutzschicht aufgebracht ist.

6. Kolbenring gemäß einem der vorstehenden Ansprüche, wobei auf der Kolbenringlauffläche in einem Bereich um den Pivotpunkt keine Schutzschicht aufgebracht ist und wobei auf die restliche Kolbenringlauffläche und den Laufkanten außerhalb dieses Bereiches eine Schutzschicht aufgebracht ist.

7. Kolbenring gemäß einem der vorstehenden Ansprüche, wobei die Funktionsschicht als eine wasserstoff- bzw. halogenfreie DLC-Schicht gebildet ist.

8. Kolbenring gemäß einem der vorstehenden Ansprüche, wobei die oberflächlichen Einlagerungen der Schutzschicht bei einer Schichtdicke der Funktionsschicht kleiner als 10 µm einen Flächenanteil zwischen 10% und 30% der Gesamtfläche aufweisen, bzw. bei einer Schichtdicke der Funktionsschicht größer als 10 µm einen Flächenanteil zwischen 20% und 40% der Gesamtfläche aufweisen.

9. Kolbenring gemäß einem der vorstehenden Ansprüche, wobei auf der Kolbenringlauffläche der Rauheitswert Rpk im Bereich von 0,03 µm bis 0,1 µm liegt, und der Rauheitswert Rk im Bereich von 0,15 µm bis 0,3 µm liegt.

10. Verfahren zur Herstellung eines beschichteten Kolbenrings, umfassend Bereitstellen eines Kolbenringkörpers;
Aufbringen einer DLC-Schicht als Funktionsschicht zumindest auf die Lauffläche des Kolbenringkörpers;
Aufbringen einer Schutzschicht auf die Funktionsschicht;
teilweises Abtragen der Schutzschicht, so dass nur noch in Vertiefungen der Oberfläche der Funktionsschicht Einlagerungen vorhanden sind.

11. Verfahren gemäß Anspruch 10, wobei der Kolbenringkörper vor Aufbringen der Funktionsschicht aufgeraut wird, insbesondere diejenigen Flächen, die mit einer Funktionsschicht versehen werden.

12. Verfahren gemäß einem der Ansprüche 10-11, wobei die Funktionsschicht durch ein Lichtbogenverfahren oder ein Sputterverfahren aufgebracht wird.

13. Verfahren gemäß einem der Ansprüche 10-12, wobei die Funktionsschicht nach ihrem Aufbringen einen Rauheitswert Rpk im Bereich von 0,15 µm bis 0,5 µm aufweist, und einen Rauheitswert Rk im Bereich von 0,3 µm bis 0,7 µm aufweist.

14. Verfahren gemäß einem der Ansprüche 10-13, wobei die Schutzschicht durch ein PVD-Verfahren aufgebracht wird.

15. Verfahren gemäß einem der Ansprüche 10-14, wobei das Material der Schutzschicht ein Metall, eine Metalllegierung oder ein Metallnitrid umfasst, vorzugsweise Chrom, Aluminium, Titannitrid oder Vanadiumnitrid.

16. Verfahren gemäß einem der Ansprüche 10-15, wobei die Aufbringdicke des Materials der Schutzschicht zwischen 0,05 µm und 1 µm liegt, bei einer Schichtdicke der Funktionsschicht größer als 20 µm bevorzugt zwischen 0,2 µm und 0,4 µm, bzw. bei einer Schichtdicke der Funktionsschicht kleiner als 20 µm bevorzugt zwischen 0,05 µm und 0,4 µm, weiter bevorzugt zwischen 0,1 µm und 0,2 µm.

17. Verfahren gemäß einem der Ansprüche 10-16, wobei der Abtrageschritt Läppen, insbesondere Rundläppen, umfasst.

18. Verfahren gemäß einem der Ansprüche 10-17, wobei der Abtrageschritt fortgesetzt wird, bis der Flächenanteil der oberflächlichen Einlagerungen bei einer Schichtdicke der Funktionsschicht kleiner als 10 µm zwischen 10% und 30% der Gesamtfläche liegt, bzw. bei einer Schichtdicke der Funktionsschicht größer als 10 µm zwischen 20% und 40% der Gesamtfläche liegt.

## Claims

1. A piston ring, comprising a piston ring body,
wherein a DLC layer is applied on the outer surface of the piston ring body at least on the running surface as functional layer,
wherein a protective layer is applied on the functional layer at least on partial surfaces of the piston ring running surface,
wherein the protective layer consists of a material which is different from the material of the functional layer and has a greater thermal resistance than that,
wherein the protective layer is present in form of superficial enclosures in recesses of the functional layer.

2. The piston ring according to claim 1, wherein the protective layer was applied by a PVD process.

3. The piston ring according to one of the preceding claims, wherein the thickness of the protective layer is less than 5 µm, preferably less than 2 µm, most preferably less than 1 µm.

4. The piston ring according to one of the preceding claims, wherein the protective layer consists of a metal or a metal nitride.

5. The piston ring according to one of the preceding claims, wherein a protective layer is applied on the entire piston ring running surface.

6. The piston ring according to one of the preceding claims, wherein no protective layer is applied on the piston ring running surface in a region around the pivot point and wherein a protective layer is applied on the rest of the piston ring running surface and the running edges outside of this region.

7. The piston ring according to one of the preceding claims, wherein the functional layer is formed as a DLC layer that is free from hydrogen and halogen.

8. The piston ring according to one of the preceding claims, wherein the superficial enclosures of the protective layer have a surface portion between 10 % and 30 % of the total surface when the layer thickness of the functional layer is smaller than 10 µm or have a surface portion between 20 % and 40 % of the total surface when the layer thickness of the functional layer is greater than 10 µm.

9. The piston ring according to one of the preceding claims, wherein the Rpk roughness value on the piston ring running surface is in the range from 0.03 µm to 0.1 µm and the Rk roughness value is in the range from 0.15 µm to 0.3 µm.

10. A method for producing a coated piston ring, comprising
providing a piston ring body;
applying a DLC layer as functional layer at least on the running surface of the piston ring body;
applying a protective layer on the functional layer;
partially removing the protective layer, so that enclosures are present only in recesses of the surface of the functional layer.

11. The method according to claim 10, wherein the piston ring body is roughened before the functional layer is applied, particularly those surfaces that are provided with a functional layer.

12. The method according to one of claims 10-11, wherein the functional layer is applied by an arc process or a sputtering process.

13. The method according to one of claims 10-12, wherein the functional layer has a Rpk roughness value in the range from 0.15 µm to 0.5 µm and a Rk roughness value in the range from 0.3 µm to 0.7 µm after its application.

14. The method according to one of claims 10-13, wherein the protective layer is applied by a PVD process.

15. The method according to one of claims 10-14, wherein the material of the protective layer comprises a metal, a metal alloy or a metal nitride, preferably chromium, aluminum, titanium nitride or vanadium nitride.

16. The method according to one of claims 10-15, wherein the application thickness of the material of the protective layer is between 0.05 µm and 1 µm when a layer thickness of the functional layer is greater than 20 µm, preferably between 0.2 µm and 0.4 µm, or when a layer thickness of the functional layer is smaller than 20 µm, preferably between 0.05 µm and 0.4 µm, more preferably between 0.1 µm and 0.2 µm.

17. The method according to one of claims 10-16, wherein the removal step comprises lapping, particularly cylindrical lapping.

18. The method according to one of claims 10-17, wherein the removal step is continued until the surface portion of the superficial enclosures is between 10 % and 30 % of the total surface when a layer thickness of the functional layer is less than 10 µm, or between 20 % and 40 % of the total surface when a layer thickness of the functional coating is greater than 10 µm.

## Revendications

1. Segment de piston, comprenant un corps de segment de piston,
dans lequel sur la surface extérieure du corps de segment de piston au moins sur la surface de roulement une couche DLC est appliquée en tant que couche fonctionnelle,
dans lequel une couche de protection est appliquée sur la couche fonctionnelle au moins sur des surfaces partielles de la surface de roulement du segment de piston,
dans lequel la couche de protection est constituée d'un matériau différent du matériau de la couche fonctionnelle et présente une résistance à la température plus élevée que celui-ci,
dans lequel la couche de protection se présente sous la forme de dépôts superficiels dans des évidements de la couche fonctionnelle.

2. Segment de piston selon la revendication 1, dans lequel la couche de protection a été appliquée par un procédé PVD.

3. Segment de piston selon une des revendications précédentes, dans lequel l'épaisseur de la couche de protection est inférieure à 5 µm, de préférence inférieure à 2 µm, tout particulièrement inférieure à 1 µm.

4. Segment de piston selon une des revendications précédentes, dans lequel la couche de protection est constituée d'un métal ou d'un nitrure métallique.

5. Segment de piston selon une des revendications précédentes, dans lequel sur la totalité de la surface de roulement du segment de piston une couche de protection est appliquée.

6. Segment de piston selon une des revendications précédentes, dans lequel sur la surface de roulement du segment de piston dans une zone autour du point de pivot aucune couche de protection n'est appliquée et dans lequel sur la surface de roulement du segment de piston restante et les bords de roulement une couche de protection est appliquée en dehors de cette zone.

7. Segment de piston selon une des revendications précédentes, dans lequel la couche fonctionnelle est réalisée sous la forme d'une couche DLC sans hydrogène ni halogène.

8. Segment de piston selon une des revendications précédentes, dans lequel les dépôts en surface de la couche de protection présentent, en présence d'une épaisseur de couche de la couche fonctionnelle inférieure à 10 µm, une proportion de surface comprise entre 10% et 30% de la surface totale, ou, en présence d'une épaisseur de couche de la couche fonctionnelle supérieure à 10 µm, une proportion de surface entre 20 et 40% de la superficie totale.

9. Segment de piston selon une des revendications précédentes, dans lequel sur la surface de roulement de segment de piston, la valeur de rugosité Rpk est comprise entre 0,03 µm et 0,1 µm et la valeur de rugosité Rk est comprise entre 0,15 µm et 0,3 µm.

10. Procédé de fabrication d'un segment de piston revêtu, comprenant :
la fourniture d'un corps de segment de piston ;
l'application d'une couche DLC comme couche fonctionnelle au moins sur la surface de roulement du corps de segment de piston ;
l'application d'une couche de protection sur la couche fonctionnelle ;
l'élimination partielle de la couche protectrice, de sorte que des dépôts soient présents uniquement dans les évidements de la surface de la couche fonctionnelle.

11. Procédé selon la revendication 10, dans lequel le corps de segment de piston avant l'application de la couche fonctionnelle est rendu rugueux, en particulier les surfaces qui sont pourvues d'une couche fonctionnelle.

12. Procédé selon une quelconque des revendications 10 à 11, dans lequel la couche fonctionnelle est appliquée par un procédé à l'arc ou un procédé de pulvérisation cathodique.

13. Procédé selon une quelconque des revendications 10 à 12, dans lequel la couche fonctionnelle, après son application, présente une valeur de rugosité Rpk comprise entre 0,15 µm et 0,5 µm, et une valeur de rugosité Rk comprise entre 0,3 µm et 0,7 µm.

14. Procédé selon une quelconque des revendications 10 à 13, dans lequel la couche de protection est appliquée par un procédé PVD.

15. Procédé selon une quelconque des revendications 10 à 14, dans lequel le matériau de la couche de protection comprend un métal, un alliage métallique ou un nitrure métallique, de préférence du chrome, de l'aluminium, du nitrure de titane ou du nitrure de vanadium.

16. Procédé selon une quelconque des revendications 10 à 15, dans lequel l'épaisseur d'application du matériau de la couche de protection est comprise entre 0,05 µm et 1 µm, avec une épaisseur de couche de la couche fonctionnelle supérieure à 20 µm, de préférence comprise entre 0,2 µm et 0,4 µm, ou avec une épaisseur de couche de la couche fonctionnelle inférieure à 20 µm, de préférence comprise entre 0,05 µm et 0,4 µm, plus préférentiellement entre 0,1 µm et 0,2 µm.

17. Procédé selon une quelconque des revendications 10 à 16, dans lequel l'étape d'élimination comprend un rodage, en particulier un rodage circulaire.

18. Procédé selon une quelconque des revendications 10 à 17, dans lequel l'étape d'élimination est poursuivie jusqu'à ce que la superficie des dépôts en surface en présence d'une épaisseur de couche de la couche fonctionnelle inférieure à 10 µm soit comprise entre 10% et 30% de la surface totale, ou en présence d'une épaisseur de couche de la couche fonctionnelle supérieure à 10 µm soit comprise entre 20% et 40% de la surface totale.
